# EUROPEAN PATENT APPLICATION

(11) **EP 4 531 203 A1**
(43) Date of publication of application: **02.04.2025**
(21) Application number: 23200394.7
(22) Date of filing: 28.09.2023
(51) Int. Cl.: H01Q 1/22, H01Q 1/48, H01Q 5/357, H01Q 5/378, H01Q 9/42

(54) **SEMICONDUCTOR PACKAGE WITH RFIC AND ANTENNA**

(71) Applicant: INTEL Corporation, Santa Clara, CA 95054 (US)
(72) Inventor: ZHOU, Zhen, Chandler, 85248 (US); YAMADA, Shuhei, Vancouver, 98684 (US); YANG, Tae Young, Portland, 97229 (US); ACIKALIN, Tolga, San Jose, 95118 (US); FOUST, Kenneth, Beaverton, 97007 (US); HORINE, Bryce, Portland, 97229 (US); LIU, Renzhi, Portland, 97229 (US)
(74) Representative: 2SPL Patentanwälte PartG mbB

(57) **Abstract**

The present disclosure relates to a semiconductor package (100; 200) comprising a substrate (110), a radio frequency integrated circuit (120) attached to the substrate (110), optionally at least one semiconductor die (220) attached to the substrate (110) and coupled to the RFIC (120) via one or more signal lines (150), a molding compound (130) encapsulating the RFIC (120) and the optional semiconductor die (220), and an antenna (140) formed on the molding compound (130) and coupled to the RFIC (140).

## Description

### Field

The present disclosure generally relates to methods and apparatuses for communicating between one or more chips and other devices, such as chip-to-motherboard (C2M), chip-to-chip (C2C), package to package (P2P), and package-to-motherboard (P2M) communications.

### Background

Three-dimensional (3D) chiplets have become a mainstream and multivendor interoperable system architecture moving forward. A chiplet is a concept in semiconductor design and manufacturing where a single integrated circuit (IC) is built using multiple smaller semiconductor "chiplets" instead of a single monolithic die. Thus, a chiplet may be regarded as a tiny IC that contains a well-defined subset of functionality. It may be designed to be combined with other chiplets on an interposer in a single package. The debut of Universal Chiplet Interconnect Express (UCIe) may further facilitate the implementation of chiplet-based architectures. UCIe is an open specification for a die-to-die interconnect and serial bus between chiplets.

Even though 3D chiplets may provide numerous benefits, such as lower cost, higher scalability, quick deliver time, etc., they come with some trade-offs including more demands on testing as well as more I/O (input/output) escape and thermal constrains. It is expected that more pins will be reserved for testing and debugging, which will make the congested I/O escape even worse, further deteriorate the signal integrity of the high-speed I/Os, and induce more switching noises to the power delivery network.

Besides the sideband signal occupancy in 3D chiplets, some test and/or control signals which can be broadcasted by nature must be routed to their destinations in a way of point-to-point routing. Such awkward routing scheme may further crowd the already congested chiplet rout-ings.

Without increasing the base die area, adding more through-silicon vias (TSVs) on a base die, and expanding the package area, the signal integrity and power integrity of a 3D heterogenous chiplet system should be expected to get the already congested routing/escaping situation much worse. Unfortunately, the base die cannot infinitely grow without reaching a singularity imposed by the size of a reticle, and practically base die size can grow up to a point.

### Brief description of the Figures

Some examples of apparatuses and/or methods will be described in the following by way of example only, and with reference to the accompanying figures, in which
- Fig. 1: shows a semiconductor package according to the present disclosure, the semiconductor package comprising an RFIC and an antenna;
- Fig. 2: shows a semiconductor package according to the present disclosure, the semiconductor package comprising an RFIC, a further IC, and an antenna;
- Fig. 3: shows a block diagram of an RFIC in a semiconductor package;
- Fig. 4: shows a top view of an antenna integrated in or on a semiconductor package;
- Fig. 5: shows a back view of the antenna integrated in or on the semiconductor package;
- Fig. 6: shows the antenna over a ground plane;
- Fig. 7: shows a top view of the ground plane;
- Fig. 8A: shows an alternative implementation of the antenna;
- Fig. 8B: shows an implementation of a first separate antenna;
- Fig. 8C: illustrates a reflection coefficient vs. frequency of the first separate antenna;
- Fig. 8D: shows an implementation of a second separate antenna;
- Fig. 8E: illustrates a reflection coefficient vs. frequency of the second separate antenna;
- Fig. 8F: shows an implementation of a combined antenna;
- Fig. 8G: illustrates a reflection coefficient vs. frequency of the combined antenna;
- Fig. 9A: shows an example of wireless chip-to-chip communication according to the present disclosure;
- Fig. 9B: shows an example of wireless package-to-package communication according to the present disclosure; and
- Fig. 9C: shows an example of wireless motherboard-to-package communication according to the present disclosure.

### Detailed Description

Some examples are now described in more detail with reference to the enclosed figures. However, other possible examples are not limited to the features of these embodiments described in detail. Other examples may include modifications of the features as well as equivalents and alternatives to the features. Furthermore, the terminology used herein to describe certain examples should not be restrictive of further possible examples.

Throughout the description of the figures same or similar reference numerals refer to same or similar elements and/or features, which may be identical or implemented in a modified form while providing the same or a similar function. The thickness of lines, layers and/or areas in the figures may also be exaggerated for clarification.

When two elements A and B are combined using an "or", this is to be understood as disclosing all possible combinations, i.e. only A, only B as well as A and B, unless expressly defined otherwise in the individual case. As an alternative wording for the same combinations, "at least one of A and B" or "A and/or B" may be used. This applies equivalently to combinations of more than two elements.

If a singular form, such as "a", "an" and "the" is used and the use of only a single element is not defined as mandatory either explicitly or implicitly, further examples may also use several elements to implement the same function. If a function is described below as implemented using multiple elements, further examples may implement the same function using a single element or a single processing entity. It is further understood that the terms "include", "including", "comprise" and/or "comprising", when used, describe the presence of the specified features, integers, steps, operations, processes, elements, components and/or a group thereof, but do not exclude the presence or addition of one or more other features, integers, steps, operations, processes, elements, components and/or a group thereof.

Array antenna designs have been emphasized for mm-wave communications to extend communication range. Element antenna size miniaturization has been overlooked because element antenna size at mm-wave is already small enough. However, antenna size and formfactor may become important when antennas is integrated in semiconductor packages and chiplets for short-range wireless I/O (WIO) applications.

Alternatively, various compact antenna structures, which have been developed for sub-7-GHz applications (e.g., 5G, Wi-Fi, Bluetooth, GPS), may be scaled to mm-wave frequency range for supporting WIO. However, these antenna structures may not be easily integrated into packages and chiplets. In addition, their operational bandwidth (< 2 GHz) is often limited due to spectrum availability below 11 GHz, compared to mm-wave spectrum > 30 GHz. Ultra-wideband antennas could be considered, but their structures may also not be easily integrated into packages and chiplets due to their formfactor (3D structure or relatively large footprint).

The present disclosure proposes a WIO concept for semiconductor packages and chiplets.

According to a first aspect, the present disclosure proposes a semiconductor package. The semiconductor package comprises a substrate. The semiconductor package comprises a radio frequency integrated circuit (RFIC) attached or mounted to the substrate. Optionally, the semiconductor package also comprises at least one further IC attached or mounted to the substrate and coupled to the RFIC via one or more signal lines. The semiconductor package comprises a molding compound (or mold) encapsulating the RFIC and the optional at least one further IC. The semiconductor package comprises an antenna formed in or on the molding compound and coupled to the RFIC.

The optional at least one further IC and/or the RFIC in the semiconductor package may be respective chiplets, for example. That is, the optional at least one further IC and/or the RFIC may be formed as separate chiplets (monolithic dies) instead of being formed on a common monolithic die. The RFIC and the antenna integrated in the semiconductor package can be used as a wireless communications interface for wireless communication between the optional at least one further IC inside of or internal to the semiconductor package and other components outside of or external to the semiconductor package. The wireless communication may include chip-to-motherboard (C2M), chip-to-chip (C2C), package to package (P2P), and package-to-motherboard (P2M) wireless communications.

In some example implementations, the optional at least one further IC is configured to send and/or receive one or more baseband test and/or debug signals to/from the RFIC. The test and/or debug signals may be predefined signals, such as predefined test signal patterns (test vectors), for example. Consequently, the RFIC may be configured to wirelessly send and/or receive test and/or debug signals to/from the optional further IC via the antenna.

In some example implementations, the RFIC comprises a baseband interface configured to receive one or more baseband test and/or debug signals from the optional further IC (or from somewhere else, such as a PCB, for example) via one or more signal lines, a modulator configured to modulate an RF carrier signal based on the one or more baseband test and/or debug signals to obtain a modulated RF signal, and a transmit interface configured to feed the modulated RF signal to the antenna. Likewise, the RFIC may comprise a receive interface configured to receive a modulated RF signal from the antenna, a demodulator configured to demodulate the RF carrier signal to obtain one or more baseband test and/or debug signals, and a baseband interface configured to transmit the one or more baseband test and/or debug signals to the optional further IC (or to somewhere else, such as a PCB, for example) via one or more signal lines.

In some example implementations, the antenna is coupled to the RFIC via one or more redistribution layers (RDLs) of the semiconductor package. A RDL is a component in the packaging of ICs or chips. It may be used to enable the connection between fine-pitch bond pads on the chip and larger-pitch input/output (I/O) connections on the substrate.

In some example implementations, also optional further IC (e.g., chiplet) is coupled to the RFIC (e.g., RF chiplet) via one or more RDLs of the semiconductor package.

In some example implementations, the molding compound laterally extends beyond the RFIC and the antenna is formed in or on the molding compound laterally adjacent to the RFIC. In this way, good radiation characteristics of the antenna may be achieved.

In some example implementations, the antenna is formed at an edge of the molding compound. In this way, good radiation characteristics of the antenna may be achieved.

In some example implementations, the semiconductor package further comprises a (conductive) ground plane formed in the molding compound as a counterpoise to the antenna. The ground plane may improve the antenna's radiation pattern, gain, and/or efficiency.

In some example implementations, the ground plane is formed in at least a first metal layer in the molding compound and the antenna is formed in at least a second metal layer above or below the ground plane. The skilled person having benefit from the present disclosure will appreciate that the ground plane as well as the antenna may be formed in more than one metal layer, respectively.

In some example implementations, the antenna is coupled to the ground plane by means of at least one shorting via. For example, the antenna may be coupled to the ground plane by means of exactly one (a single) shorting via. Shorting vias may be used to enhance the antenna's performance in terms of bandwidth, efficiency, and radiation pattern. Adding a shorting via can also modify the antenna's electrical length and, consequently, its impedance. This can help to not only miniaturize physical size of antenna, but also achieve a better impedance match between the antenna and the RFIC, minimizing signal reflections and improving overall system efficiency. By strategically placing one or more shorting vias, the antenna's impedance can be modified to achieve a broader bandwidth, making it suitable for a wider frequency range. Shorting vias can also be used as a tuning element to adjust the resonance frequency of an antenna. This is particularly useful when fine-tuning the antenna to achieve optimal performance at a specific frequency.

In some example implementations, the antenna is coupled to the RFIC by means of a feeding via extending to or through the ground plane. A design of the feeding via, as well as the associated transmission line on the RDLs, can be used for impedance matching between the RFIC and the antenna, for example.

In some example implementations, the antenna comprises a floating via extending from a metal layer in which the antenna is implemented towards another metal layer of the ground plane. The floating via refers to a via that is connected to the antenna on the one end but not connected to a fixed voltage reference or ground on the other end. The floating via may be used for antenna tuning, for example.

In some example implementations, the antenna comprises a first radiating element (e.g., a first metal trace) for a first frequency band and at least a second radiating element (e.g., a second metal trace) for a second frequency band. The antenna may be coupled to the RFIC and a ground plane via the first radiating element. The second radiating element may be directly or indirectly coupled to the first radiating element. Dimensions of the first and second radiating elements may be adjusted for desired frequency bands.

In some example implementations, the first radiating element comprises an inverted-F antenna, IFA, structure and the second radiating element comprises an L-shape structure. In this way, the antenna may be implemented with compact size, efficient radiation pattern, and relative ease of integration into modern electronic devices.

In some example implementations, the first radiating element linearly extends in a first direction (e.g., x-direction). The second radiating element linearly extends in parallel to the first radiating element (e.g., x-direction).

In some example implementations, the second radiating element is attached (e.g., integrally integrated) to the first radiating element at a first end of the first radiating element and linearly extends beyond an opposing second end of the first radiating element. In other words, the second radiating element may be longer than the first radiating element to radiate in a lower frequency band.

In some example implementations, the second radiating element comprises a first portion extending in the first direction (e.g., x-direction) and a second portion extending towards the first radiating element in a second direction (e.g., y-direction) perpendicular to the first direction. The second portion may be used to support (capacitive) coupling of the first and second radiating elements.

In some example implementations, a gap extends (e.g., in x-direction) between the second end of the first radiating element and the second portion of the second radiating element.

In some example implementations, the ground plane comprises a cutout portion underneath the antenna. For example, the cutout portion may be located underneath the gap between the second end of the first radiating element and the second portion of the second radiating element. The cutout portion may further improve the radiation of the antenna.

In some example implementations, the antenna is configured as a millimeter-wave (mm-wave) antenna. Millimeter-wave refers to a range of electromagnetic frequencies within the microwave spectrum. Specifically, mm-wave frequencies fall within the range of 30 gigahertz (GHz) to 300 GHz.

According to a further aspect, the present disclosure proposes a wireless communication system. The wireless communication system comprises a substrate, which may be a printed circuit board (PCB) or a motherboard, for example. The wireless communication system comprises a first semiconductor package mounted on the substrate. The first semiconductor package comprises a first RFIC, a first molding compound encapsulating the first RFIC, and a first antenna formed on a surface of the first molding compound and coupled to the first RFIC. The wireless communication system comprises a second semiconductor package mounted on the substrate. The second semiconductor package comprises a second RFIC, a second molding compound encapsulating the second RFIC, and a second antenna formed on a surface of the second molding compound and coupled to the second RFIC. The first and the second semiconductor packages are configured to wirelessly communicate with each other using the first RFIC with the first antenna and the second RFIC with the second antenna.

In some example implementations, the first and the second semiconductor packages are configured to wirelessly exchange test and/or debug signals using the first RFIC with the first antenna and the second RFIC with the second antenna.

In some example implementations, the first and the second semiconductor packages are arranged on the substrate such that the first and the second antennas are in communication proximity to each other. For example, the first and the second antennas may face each other.

Example implementations may enable a novel wireless I/O (WIO) technology by extending a substrate (molding compound + re-distribution layer), creating an overhanging structure, and placing a mm-wave antenna in that overhanging substrate. Integrated with a RFIC bare die, it becomes overhanging InWIOM (integrated WIO module) architecture.

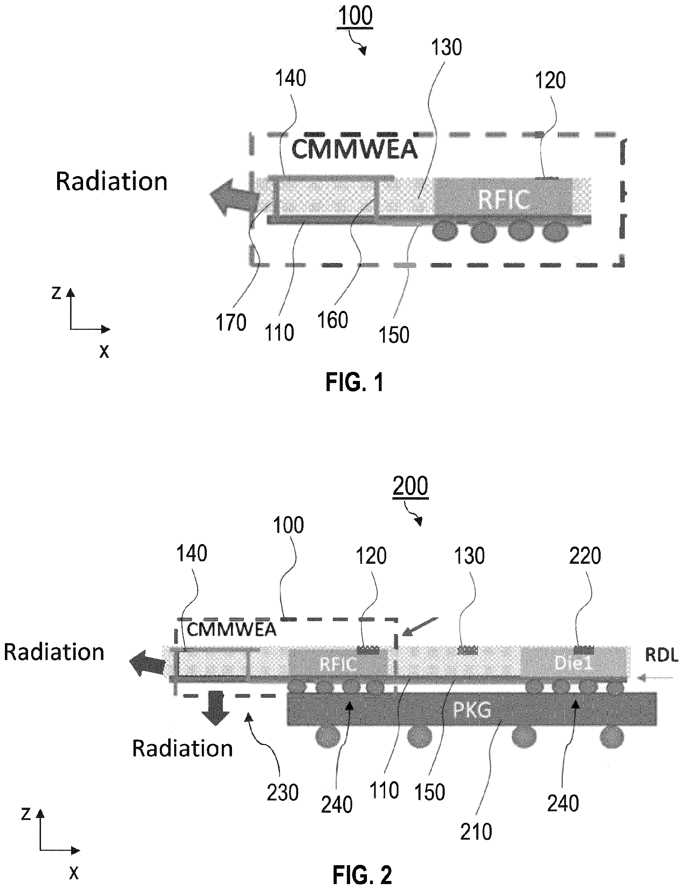

Fig. 1 shows an example of a semiconductor package 100 according to a basic implementation. In the sequel, semiconductor package 100 will also be referred to as Integrated Wireless I/O module (InWIOM).

The semiconductor package (InWIOM) 100 comprises a substrate 110, such as an interposer or a PCB. Also, a redistribution layer (RDL) and/or a dielectric portion thereof may form substrate 110. The skilled person having benefit from the present disclosure will appreciate that substrate 110 may also include various other substrate materials. For another example, substrate 110 may comprise a ceramic substrate. Ceramic substrates may be used in high-performance applications due to their excellent thermal conductivity, mechanical stability, and electrical properties. Aluminum oxide (Al₂O₃) and aluminum nitride (AlN) may be commonly used ceramic materials. Additionally or alternatively, substrate 110 may comprise an organic substrate. Organic substrates, also known as organic printed circuit boards (PCBs), may be used due to their cost-effectiveness and ease of manufacturing. They may be made from materials like epoxy resin reinforced with fiberglass (FR-4) or more advanced materials like BT (bismaleimide triazine). Organic substrates may offer good electrical insulation but have lower thermal conductivity compared to ceramics. Additionally or alternatively, substrate 110 may comprise a metal substrate. Metal-based substrates, also referred to as metal-core PCBs (MCPCBs), may comprise a metal layer as the core for enhanced thermal performance. These substrates may be used in applications requiring both efficient heat dissipation and electrical insulation. Aluminum and copper may be choices for the metal core due to their good thermal conductivity. Additionally or alternatively, substrate 110 may comprise a silicon substrate. Silicon wafers may also be used as substrates for certain types of semiconductor packaging, especially for microelectromechanical systems (MEMS) devices. Silicon may provide a well-matched coefficient of thermal expansion (CTE) with silicon ICs, which can reduce the risk of thermal stress-related issues. Additionally or alternatively, substrate 110 may comprise a glass substrate. Glass substrates may offer excellent electrical insulation and thermal stability. They may be used in certain specialized applications, such as display driver ICs and imaging sensors. Additionally or alternatively, substrate 110 may comprise a flexible substrate: Flexible substrates may be used in applications requiring bendability and lightweight designs. These substrates may be often made from flexible polymer materials and are used in devices like flexible displays, wearable electronics, and flexible circuits.

The semiconductor package (InWIOM) 100 further comprises a radio frequency integrated circuit (RFIC) 120 attached or mounted to the substrate 110 (e.g., RDL and/or a dielectric portion thereof). RFIC 120 may be a monolithically integrated die. RFIC 120 may be wire-bonded to substrate 110 using corresponding leads or pads. RFIC 120 may be configured to operate in the radio frequency (RF) range, e.g., from a few megahertz (MHz) to several gigahertz (GHz). Examples of carrier frequencies are 42 GHz and/or 63 GHz. RFIC 120 may be a specialized semiconductor chip or chiplet. RFIC 120 may be configured to process, transmit, receive, and manipulate RF signals. RFIC 120 may be configured perform a wide range of functions, such as amplification, modulation, demodulation, filtering, mixing, frequency synthesis, and signal conditioning. These functions are needed for tasks like wireless data transmission (Tx), signal reception (Rx), and the conversion of RF signals to baseband or intermediate frequencies for further processing. RFIC 120 may have a size of 1000 × 1000 µm², for example.

The semiconductor package (InWIOM) 100 further comprises a molding compound (mold) 130 encapsulating the RFIC 120 on top of the substrate (e.g., redistribution layer (RDL) 110. The molding compound 130 is configured to create the outer shell or casing that surrounds and protects the RFIC 120 and further internal electrical connections (e.g., RDLs) of the semiconductor package 100. The molding compound 130 may have a thickness (in z-direction) of 100-300 µm, for example. The molding compound 130 may comprise an epoxy resin. Epoxybased mold compounds may have excellent electrical insulation properties, good adhesion to various substrates, and ease of processing. Additionally or alternatively, molding compound 130 may comprise a bismaleimide triazine (BT) resin. BT resins may be used in high-performance semiconductor packaging due to their high-temperature stability, low moisture absorption, and good mechanical properties. They are especially suitable for applications that require reliability under harsh operating conditions. Additionally or alternatively, molding compound 130 may comprise a silicone resin. Silicone-based mold compounds may have high-temperature resistance, flexibility, and excellent moisture resistance. They may be used in applications where thermal performance and reliability are critical, such as automotive electronics. Additionally or alternatively, molding compound 130 may comprise a polyimide resin. Polyimide mold compounds may offer high-temperature resistance, excellent mechanical properties, and good chemical resistance. They may be suitable for applications requiring robust performance in extreme environments. Additionally or alternatively, molding compound 130 may comprise a thermoplastic resin. Some mold compounds may be based on thermoplastic materials such as liquid crystal polymers (LCP) or polyphenylene sulfide (PPS). These materials may offer good dimensional stability, chemical resistance, and ease of processing. Additionally or alternatively, molding compound 130 may comprise a ceramic-filled compound. Some mold compounds incorporate ceramic fillers to enhance thermal conductivity. This is particularly useful in applications where heat dissipation is crucial, such as power devices. Additionally or alternatively, molding compound 130 may comprise an underfill material. Underfill materials may be used to fill the gap between the RFIC 120 and the substrate 110 to improve mechanical bonding and reduce stress.

The semiconductor package (InWIOM) 100 further comprises an antenna structure 140 which is formed in or on the molding compound 130 and coupled to the RFIC 120. Metal layers can be incorporated into the molding compound 130. These metal layers may be used for various purposes, such as providing electromagnetic shielding, enhancing thermal performance, or serving as interconnects (e.g., redistribution layers) for integrated components within the package 100. Antenna 140 can be integrated into or onto the molding compound 130. Metal traces or layers may be used to implement the antenna's 140 radiating elements and feeding structures within the semiconductor package 100. The antenna 140 may be coupled to the RFIC 120 via one or more redistribution layers (RDLs) 150 of the semiconductor package 100. The antenna 140 may be configured for wireless mm-wave communications. Millimeter-wave refers to a range of electromagnetic frequencies within the microwave spectrum. Specifically, mm-wave frequencies fall within the range of 30 gigahertz (GHz) to 300 GHz. For example, antenna 140 and its dimensions may be designed for carrier frequencies of 42 GHz and/or 63 GHz. Antenna structure 140 may have a size of 1000~5000 × 400~300 × 100~300 µm³, for example.

The RFIC 120 and the antenna 140 integrated into semiconductor package (InWIOM) 100 may be configured to send and/or receive one or more baseband test and/or debug signals to/from the semiconductor package 100. The baseband test and/or debug signals may comprise predefined test and/or debug signals, such as predefined test patterns. In semiconductor manufacturing and design, various test and debug signals may be used to assess the functionality, performance, and reliability of integrated circuits (ICs). These signals are needed during different stages of the IC development process, including wafer testing, package testing, and system-level testing. An example of test and debug signals used for testing ICs are Scan Chains and Boundary Scan (JTAG). Scan chains may be used for structural testing of digital circuits. They may allow for the serial shifting of test patterns into the IC and the serial shifting out of responses. The Joint Test Action Group (JTAG) standard, also known as IEEE 1149.1, defines a standardized interface for testing and debugging digital ICs. JTAG enables boundary scan, which can test the connections of input and output pins of the IC. Another example of test and debug signals used for testing ICs is Built-In Self-Test (BIST). BIST circuits are integrated into the IC to perform self-testing. BIST can include logic, memory, and other test structures that help verify the functionality of the IC. BIST can reduce the need for external test equipment and simplify the testing process. Many ICs or chiplets have built-in test modes that enable specific functions to facilitate testing. These modes can be accessed through control pins or configuration registers and may include features like loopback testing or specific signal generation. Some ICs may have dedicated debug ports that allow developers to connect to the chip for real-time debugging and monitoring of internal signals. Debug ports can provide access to internal buses, registers, and other essential debugging information.

Conventionally, the baseband test and/or debug signals are routed to and from the semiconductor package 100 and ICs thereof via signal lines or traces. The present disclosure proposes the RFIC 120 and the antenna 140 within the semiconductor package (InWIOM) 100 as a wireless interface for test and/or debug signals (also referred to as sideband signals). The skilled person having benefit from the present disclosure will appreciate that also other signals (e.g., non-predetermined useful information bearing signals) may be exchanged via the RFIC 120 and the antenna 140. RFIC 120 and antenna 140 may be used for wireless chip(let)-to-chip(let) communication, wireless package-to-package communication, and/or wireless communication for testing and debugging.

As can be seen in Fig. 1, the molding compound 130 may laterally extend beyond the RFIC 120 (in x-direction). The antenna 140 may be formed in or on the molding compound 130 laterally adjacent to the RFIC 120. In the illustrated example, antenna 140 is formed in or on the molding compound 130 left of RFIC 120. For example, antenna 140 may be implemented as 3D or as a 2D (planar) antenna in or on the molding compound 130. In the illustrated example, antenna 140 is implemented as an antenna structure in a metal layer on an upper surface of the molding compound 130. The skilled person having benefit from the present disclosure will appreciate that the lower surface of the molding compound 130 or a metal layer within the molding compound 130 would also be feasible options.

Antenna 140 may be coupled to the RFIC 120 by means of a feeding via 160 extending from antenna 140 to a redistribution layer 150 which again is coupled to one or more RF I/O pins (RF interface) of RFIC 120. Antenna 140 may also comprise a floating via 170 extending from the antenna 140 or a radiating element thereof away from the antenna 140 towards substrate 110. Floating via 170 is a disconnected or isolated element that can impact the performance of the integrated antenna 140.

The semiconductor package (InWIOM) 100 illustrated in Fig. 1 may enable a wireless I/O (WIO) technology by extending substrate 110 (molding compound 130 + re-distribution layer 150), creating an overhanging structure, and placing a mm-wave antenna 140 in that overhanging substrate. Integrated with the RFIC bare die 140, it becomes an overhanging InWIOM (integrated WIO module) architecture. The overhanging InWIOM 100 may be used for improving link performance through clear line-of-sight wireless link, reducing pin counts reserved for sideband and some control signals, avoiding routing congestion, enabling multidrop and broadcasting capability, and reducing die and package cost by slowing down the die and package area growth. The overhanging InWIOM architecture can support various WIO application scenarios including wireless chip-to-motherboard (C2M), chip-to-chip (C2C), package to package (P2P), and package-to-motherboard (P2M) communications.

In the example implementation of semiconductor package 200 shown in Fig. 2, the semiconductor package 200 comprises InWIOM 100 and further comprises a separate semiconductor chip(let) 220 mounted on the substrate 110 adjacent (right) to the RFIC 120 and encapsulated by molding compound 130. RFIC 120 and semiconductor chip(let) 220 may be different monolithically integrated semiconductor dies. The semiconductor chip(let) 220 may be configured to, during a test and/or debug mode, send and/or receive one or more predetermined baseband test and/or debug signals to/from the RFIC 120. For this purpose, the semiconductor chip(let) 220 may be coupled to the RFIC 120 via one or more redistribution layers 150 of the semiconductor package 200. That is, baseband test and/or debug signals may be exchanged between the semiconductor chip(let) 220 and the RFIC 120 via redistribution layers 150 routed within semiconductor package 200.

Semiconductor package 200 may be wire-bonded to a separate base substrate 210 using corresponding leads or pads 240. The base substrate 210 underneath semiconductor package 200 may be a base die, a printed circuit board (PCB), or the like. Substrate 110 and the base substrate 210 underneath may only partially overlap in horizontal direction (x-direction). As shown in Fig. 2, an overhanging portion 230 of semiconductor package 200 comprising antenna 140 (e.g., the portion left of RFIC 120) may extend beyond the base substrate 210 in horizontal direction, allowing line-of-sight radiation in multiple directions (e.g., downwards and sidewards).

In an InWIOM 100, the RFIC 120 and a compact mm-wave edge antenna (CMMWEA) 140 may be integrated through Fan-out Wafer Level Packaging (FOWLP) techniques commonly implemented in a 3D heterogenous IC integration. In the integration, the RFIC 120 may be first placed on a wafer carrier, then the molding compound 130 may be applied to further secure the RFIC 120 on the wafer carrier 110. Afterwards, the wafer carrier may be removed and bumping pads 240 of the RFIC 120 may be exposed, and the redistribution layer deposition may start. To fully take advantage of FOWLP, the CMMWEA 140 may have a simple two-layer stack-up so it can be fabricated using the molding compound 130 as an antenna substrate whose dielectric constant (DK) and thickness can be tuned to have a desired antenna performance. Then CMMWEA 140 and RFIC 120 can be interconnected through redistribution layers (RDLs) 150.

To take advantage of the wireless I/O, the present disclosure proposes an integrated wireless I/O module (InWIOM) 100 which may be co-packaged with at least one further semiconductor chip(let) 220 (main die) using wafer level redistribution layer (RDL) to have InWIOM 100 share some of "must keep" low-speed configuration signal buses, e.g., Serial Peripheral Interface (SPI) pins (usually 4 pins), and power delivery network with the main die 220 as illustrated in Fig. 2 and form an overhanging line-of-sight wireless link.

As far as a data rate offered by InWIOM 100 is concerned, many sideband signals (e.g., test and debug signals) can be serialized and communicated wirelessly through an overhanging InWIOM 100 rather than going through the package pins/pads 240, and hence the number of pins reserved for sideband signals can be drastically decreased. The sideband signal pin counts reduction directly translates to the base die 210 and package area saving (thus, cost saving as well). As far as operating InWIOMs is concerned, they only require limited pins going through the package 100 and the base die 210. Moreover, those pins are not necessarily to be dedicated pins. They can be shared among InWIOMs 100 and the main dies 220. For example, the major IO/pins that are required for configuring the InWIOM 100, using protocols such as SPI (Serial Peripheral Interface) or I2C (Inter-Integrated Circuit) / I3C (Improved Inter-Integrated Circuit), may only be routed between InWIOM 100 and the main dies 220 without having direct connection to IO pins on the package 100. As a result, the package pins reserved particularly for InWIOM can be kept as zero if shared with the remaining sideband channels of the main dies 220 or a very limited number (e.g., 2 to 4) for supporting independent off-package SPI/I2C/I3C configuration for the module. This leads to more base die and package real estate savings apparently because the overall package size is not only determined by the number of the bumps, but also is fixed by the BGA pitch which is currently set to be 650 µm versus die-to-package C4 /C2 bump pitch of 100 µm.

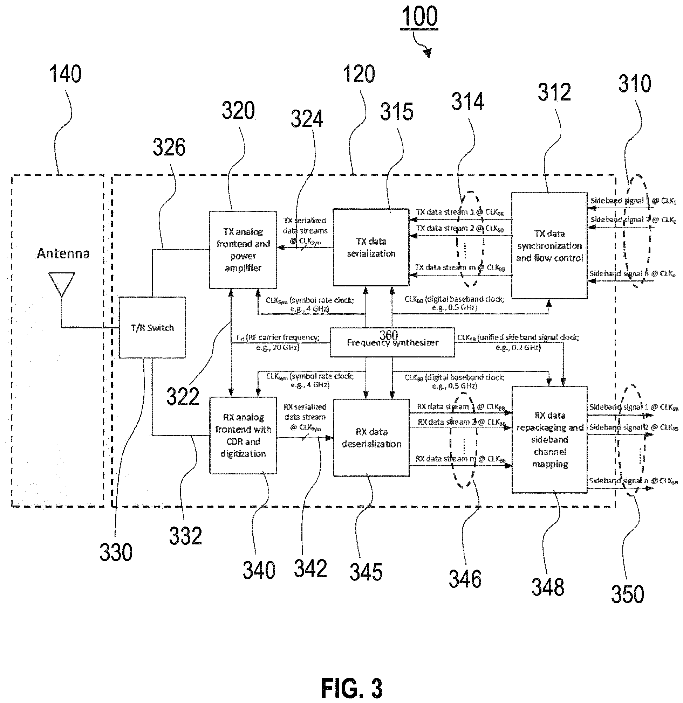

As shown in the block diagram of **Fig. 3****,** the InWIOM 100 or RFIC 120 may comprise a baseband interface 310 configured to receive one or more baseband test and/or debug signals from the semiconductor chip(let) 220 via one or more signal lines (RDLs). Baseband interface 310 to semiconductor chip(let) 220 may be a wired interface using one or more signal lines (RDLs) between RFIC 120 and chip(let) 220 or other devices (e.g., a PCB). Further, RFIC 120 may comprise modulator circuitry 320 configured to modulate an RF carrier signal 322 based on the one or more baseband test and/or debug signals 324 to obtain a modulated RF signal 326 carrying the test and/or debug signals. The RF carrier signal 322 may be synthesized in a frequency synthesizer 360 of RFIC 120. The RFIC 120 may further comprise a Tx interface 330 configured to feed the modulated RF signal 326 to the antenna 140. Tx interface 330 to antenna 140 may be a wired interface using one or more signal lines (RDLs) between RFIC 120 and antenna 140. Here, Tx interface 330 comprises a Tx/Rx switch such that Tx interface 330 may also act as Rx interface 330. Thus, the RFIC 140 also comprises a Rx interface 330 configured to receive a modulated RF signal 332 from the antenna 140. Rx interface 330 to antenna 140 may be a wired interface using one or more signal lines (RDLs) between RFIC 120 and antenna 140. A demodulator 340 of RFIC 120 is configured to demodulate the received RF carrier signal 332 to obtain one or more received baseband test and/or debug signals 342. A baseband interface 350 of RFIC 120 is configured to transmit the one or more received baseband test and/or debug signals to the semiconductor chip(let) 220 or other devices (e.g., a PCB) via one or more signal lines (RDLs). The corresponding interface to chip(let) 220 may be a wired interface using one or more signal lines (RDLs) between RFIC 120 and chip(let) 220.

Fig. 3 presents a block diagram which illustrates the components in an Integrated Wireless I/O Module (InWIOM) 100 including RFIC 120 and antenna 140. On the transmitter (Tx) side, the InWIOM module 100 or RFIC 120 may take parallel sideband signals 1, 2, ..., n at a respective clock rate of CLK₁, CLK₂, ..., CLKₙ from one or more semiconductor chip(let)s 220. The RFIC 120 may then synchronize those sideband signals to a uniformed baseband clock rate of CLK_{BB} through an asynchronous interface 312 with data flow control. The par-alleled and relatively low-speed Tx data streams 314 (e.g., a number of m streams) at CLK_{BB} (e.g. 0.5 GHz) may then be serialized to high-speed data at symbol rate of CLK_{Sym} (e.g. 4 GHz) together with information bits to symbol mapping (block 315). The serialized baseband Tx data 324 is further converted to analog domain and modulated to RF carrier frequency F_{rf} (e.g., 20 GHz) inside the Tx analog frontend 320 before amplified through power amplifier and fed to the antenna 140 for transmission.

On the receiver (Rx) side, the Rx analog frontend 340 amplifies the received signal 332 from antenna 140, down-converts the signal from RF carrier frequency F_{rf} to baseband, digitizes the signals and demodulates them into symbols at CLK_{sym}. Those symbols are then deserialized at block 345 into Rx baseband data streams 346 (e.g., a number of m streams) at CLKBB together with symbol to information bit mapping. In block 348, the Rx data streams 346 are eventually repackaged and remapped to a number of n sideband signals, however at a uniformed clock rate of CLK_{SB} at the output 350 of Rx, before sent to the one or more semiconductor chip(let)s 220. The transceiver (TRX) may be operated in a time-division duplex manner through a T/R switch 330 while sharing a single antenna 140 for the module. All those aforementioned clocks within the InWIOM module may be generated by an integrated frequency synthesizer 360 inside the module 100.

The high data throughput nature of InWIOM may significantly consolidate sideband signals. In an example, with 4 GHz symbol rate CLKSym, and 64QAM modulation, InWIOM can support a data rate of 24 Gbps for serialized sideband signals. If assuming each sideband signal is running at 300 Mbps, the example InWIOM module can consolidate a total of 80 channels. The higher speed this InWIOM module can support, the more sideband channels can be consolidated, however this may be at the cost of more power consumption and complexity of the module 100 itself.

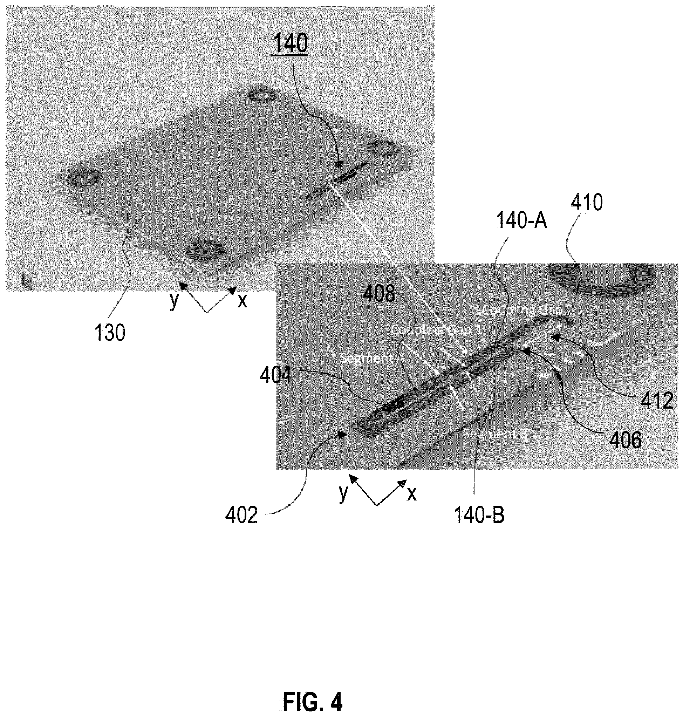

Turning now to Fig. 4, a top view of an example of integrated antenna 140 is shown.

Antenna 140 of Fig. 4 may be implemented in a metal layer on a layer of molding compound 130. For example, the layer of molding compound 130 may comprise an insulator such as SiO₂. As can be seen from the enlarged view of Fig. 4, antenna 140 may comprise two radiating elements 140-A, 140-B. Radiating element 140-A is configured for a first frequency band and radiating element 140-B is configured for a second (higher) frequency band. A respective length of radiating elements 140-A, 140-B may be in the range of X/4 of the respective carrier wavelength. The two radiating elements 140-A, 140-B basically combine two antennas into one. In the illustrated example, radiating elements 140-A, 140-B are integrally connected (attached to each other) at one end 402 of antenna 140. Form this end 402, both radiating elements 140-A, 140-B essentially extend linearly in x-direction and in parallel, separated in y-direction by a first coupling gap 404. A width of the coupling gap 404 in y-direction may be in the range of 25 µm to 100 µm, for example. Radiating element 140-A extends longer in x-direction beyond an opposing end 406 of radiating element 140-B. Ends 402 and 406 are opposite ends in x-direction. Radiating element 140-A comprises a first portion 408 extending in x-direction and a second portion 410 extending in y-direction towards radiating element 140-B. A second gap 412 extends in x-direction between the opposing end 406 of radiating element 140-B and the second portion 410 of radiating element 140-A. A width of the second gap 412 may be smaller than or equal to a quarter (1/4) length of radiating element 140-A.

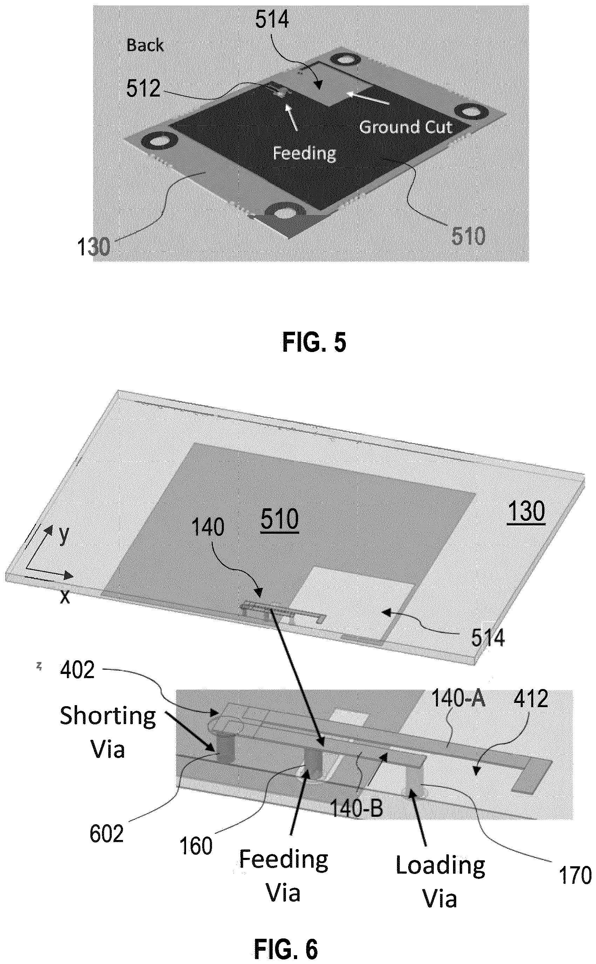

While antenna 140 is implemented on a first (e.g., upper) surface of the layer of molding compound 130, a ground plane may be implemented in a metal layer on an opposite second (e.g., lower) surface of the layer of molding compound 130 as a counterpoise to the antenna 140. An example of ground plane 510 implemented on a back surface of the layer of molding compound 130 may be seen in **Fig. 5****.**

As can be seen from Fig. 5, the ground plane 510 may essentially have a rectangular shape. Ground plane may also comprise a feeding terminal 512 for antenna 140. In an area underneath the antenna 140, ground plane 510 may have a cutout portion 514 (there is no metal in the cutout portion). The cutout portion 514 may allow for return currents at its edge and thus improve radiation characteristics of antenna 140.

Antenna 140 and ground plane 510 are shown together in Fig. 6. It can be seen that cutout portion 514 of ground plane 510 is located underneath a right portion of antenna 140. In particular, cutout portion 514 is located underneath the floating ends of radiating elements 140-A, 140-B and the second gap 412 between the opposing end 406 of radiating element 140-B and the second portion 410 of radiating element 140-A. Antenna 140 may be placed at the lower edge of ground plane 510 in y-direction. Also, cutout portion 514 extends into the ground plane 510 in y-direction from the lower edge of ground plane.

Antenna 140 is coupled to the ground plane 510 by means of at least one shorting via 602 extending from integrally formed end 402 of antenna 140 through the layer of molding compound 130 to the ground plane 510. Antenna 140 is further coupled to the RFIC 120 by means of feeding via 160 extending from radiating element 140-B through the layer of molding compound 130 to or through the ground plane 510 and to feeding terminal 512. Antenna 140 may further comprise a floating (loading) via 170 extending from end 406 of radiating element 140-B through the layer of molding compound 130 to towards the cutout portion 514 underneath.

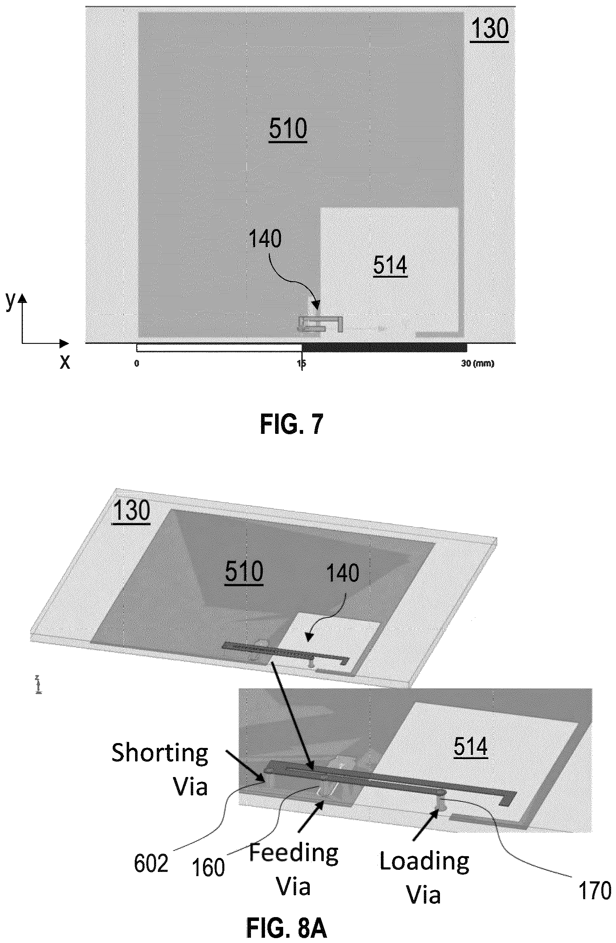

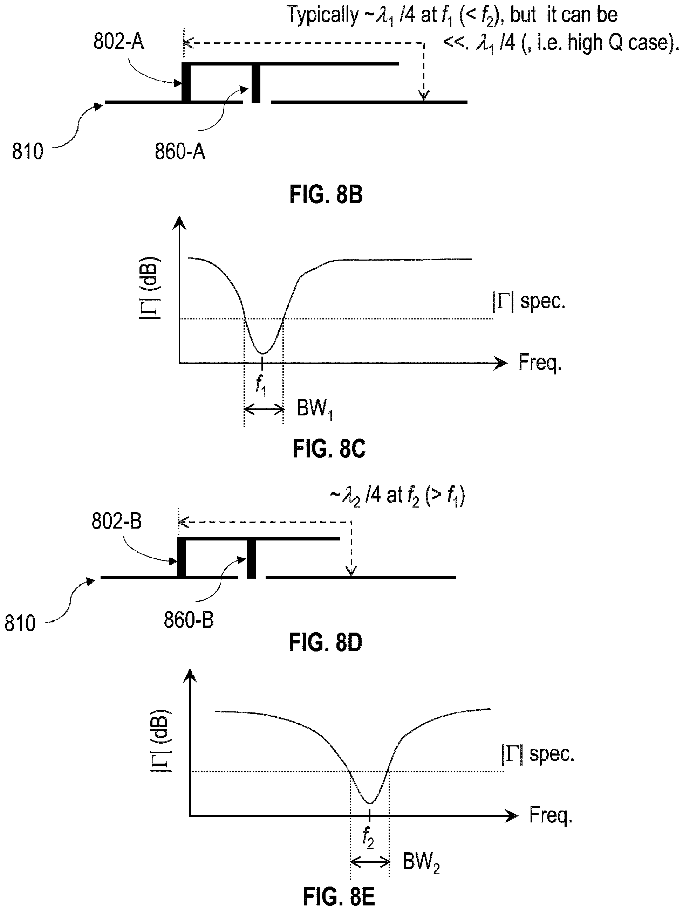

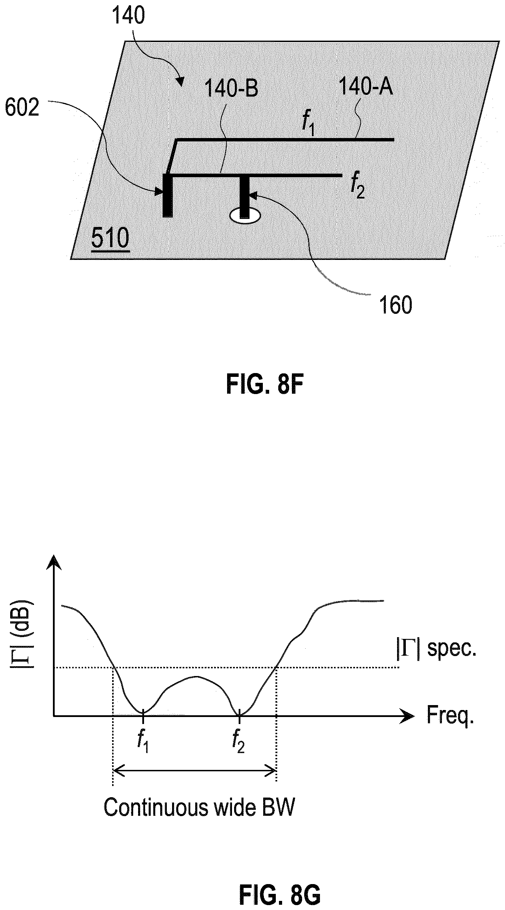

A top view of antenna 140 and ground plane 510 is illustrated in **Fig. 7** and another perspective view is provided in **Fig. 8****.**

It can be seen in the example of Fig. 7 that a width of the ground plane 510 in x-direction may be 30 mm, for example. A height of the ground plane 510 in y-direction may also be 30 mm, for example. Cutout portion 514 may be formed in the lower right corner of ground plane 510. In the illustrated example, a width of the cutout portion 514 in x-direction may be between 10 and 14 mm, for example. Likewise, a height of the cutout portion 514 in y-direction may be between 10 and 14 mm, for example. The skilled person having benefit from the present disclosure will appreciate that these dimensions are design parameters and dependent on the desired frequency bands. Antenna 140 is placed at the lower edge of the ground plane 510 and extends in x-direction from approximately the middle of ground plane 510 over the cutout portion 514. The skilled person having benefit from the present disclosure will appreciate that it is not necessary to locate the antenna 140 to the where it is shown. It can also be placed at another edge of the ground plane 510 as well. Thus, the shorting via 602 at the integrally formed end 402 of both radiating elements 140-A, 140-B may be placed in the middle of ground plane 510 in x-direction at the lower edge in y-direction. The feeding via 160 may be placed, in x-direction, between the shorting via 602 and a left edge of cutout portion 514. The floating (loading) via 170 at end 406 of radiating element 140-B may be placed, in x-direction, between the left and right edge of cutout portion 514. With a similar token, the floating (loading) via could also be placed at the end of radiating element 140-A.

Antenna 140 with the integrally connected radiating elements 140-A, 140-B combines two separate IFA/PIFA antennas operating at respective different transmission bands.

**Fig. 8B** shows a first antenna 840-A coupled to a ground plane 810 underneath radiating element 104-A via a shorting via 802-A. A feeding via 860-A couples the first antenna 840-A to a feeding terminal. First antenna 840-A may be designed for a transmit center frequency of f₁. Thus, the length of radiating element 104-A may be approximately λ₁/4, λ₁ being the wavelength at f₁. **Fig. 8C** schematically illustrates the reflection coefficient (Γ) of antenna 840-A. The reflection coefficient has its minimum at center frequency f₁ of transmission band BW₁.

**Fig. 8D** shows a second antenna 840-B coupled to ground plane 810 underneath radiating element 104-B via a shorting via 802-B. A feeding via 860-B couples the second antenna 840-B to a feeding terminal. Second antenna 840-B may be designed for a transmit center frequency of f₂ (>f₁). Thus, the length of radiating element 104-B may be approximately λ₂/4, λ₂ being the wavelength at f₂. **Fig. 8E** schematically illustrates the reflection coefficient (Γ) of antenna 840-B. The reflection coefficient has its minimum at center frequency f₂ of transmission band BW₂.

Antennas 840-A, 840-B may correspond to a so-called gamma match architecture used in IFA (Inverted F Antenna) and PIFA (Planar Inverted F Antenna) designs. The gamma match is a technique used to feed and impedance-match these types of antennas to the transmission line or RF circuit. The gamma match consists of a respective shorting via 802-A, 802-B that is placed near the respective radiating element 104-A, 104-B of the respective antenna. It is typically oriented perpendicular to the respective radiating element 104-A, 104-B, forming a "T" or "Γ" shape, which is why it's called a gamma match. A purpose of the gamma match is to adjust the impedance of the antenna to match the characteristic impedance of the transmission line or RF circuit to which it's connected. The gamma match provides a means to adjust the impedance seen at the feed point of the antenna. By adjusting the length and position of the shorting via, one can fine-tune the impedance of the antenna to match the desired value (usually 50 ohms for many RF systems).

**Fig. 8F** schematically shows antenna 140 (of Fig. 6) combining the first antenna 840-A and second antenna 840-B into one combined (and integrally formed) antenna structure. Antenna 140 is coupled to ground plane 510 underneath via single shared shorting via 602. Antenna 140 is fed via single shared feeding via 160. First radiating element 104-A of antenna 140 may be designed for a transmit center frequency of f₁. Thus, the length of radiating element 104-A may be approximately λ₁/4. Second radiating element 104-B of antenna 140 may be designed for a transmit center frequency of f₂. Thus, the length of radiating element 104-B may be approximately λ₂/4. **Fig. 8G** schematically illustrates the reflection coefficient (Γ) of combined antenna 140. The reflection coefficient has two adjacent minima at frequencies f₁, f₂, leading to a broadened transmission band BW (e.g., with center frequency (f₁+f₂)/2), with BW ≥ BW₁ + BW₂.

The present disclosure proposes a compact folded edge antenna (CFEA) 140 on a 2-layer stack-up as an exemplary antenna for InWIOM 100 for design and fabrication simplicity. On the top metal layer, two L shapes may be interconnected through the direct connection at end 402 and indirect connection such as coupling gaps 402, 412. One of L shapes (radiating element 140-B) may have a form of planar inverted-F antenna (PIFA) and the other L shape (radiating element 140-A) is connected to the shorting via 602 of the PIFA. The length of each L shape (radiating element) in x-direction determines the resonance of individual L shape while the couplings between the L shapes (radiating elements) dictates how close individual resonances might be located in a frequency range to form a multi-narrow-band or a single continuous Ultra-wideband.

On the bottom metal layer, a Coplanar Waveguide (CPW) may be designed for feeding the antenna 140. The ground plane 510 on the bottom layer may have a cut 514. The ground cut 514 on the bottom ground plane 510 may reduce the coupling between the two L-shape structures (radiating elements 140-A, 140-B) and the ground, enables them for radiation as well as alters the resonant frequencies of the overall antennas.

Furthermore, the CFEA 140 supporting mm-wave operation has a vertical structure which reminisces about a Planar Inverted-F Antenna (PIFA), but it is differentiated with a floating via 170 in the end 406 of the L structure (radiating element 140-B) as illustrated in Fig. 6 or 8. The floating via 170 is for the purpose of making the antenna 140 even more compact. In addition, a conventional PIFA does not have the additional L shape (radiating element 140-A) on the same layer providing the coupling to create multiple narrow bands or single continuous Ultra-wideband.

The proposed 2-layer compact mm-wave UWB folded edge antenna 140 may occupy only a small substrate area. The additional L-shape structure (radiating element 140-A) is connected to the shorting via 602 of the PIFA structure (radiating element 140-B). The coupling between the L-shape (radiating element 140-A) and PIFA structures (radiating element 140-B) may enable UWB operation. The antenna feed may be routed through re-distribution layer (RDL) and connected to the RFIC 120. Unlike conventional UWB antennas having multiple shorting structures, the proposed antenna may have a single shorting via 602. In addition, the feeding via 160 is only connected to the PIFA structure (radiating element 140-B), but not to the L-shape structure (radiating element 140-A). It also has a floating via 170 to make the antenna 140 more compact at the end of the PIFA (radiating element 140-B). The proposed compact mmW antenna 140 can be easily implemented in re-distribution layers (RDLs) 150 and molding compound 130 and integrated with RFIC bare die 120, which forms InWIOM 100 (integrated wireless I/O module).

An archetype of the CFEA 140 supporting an operation within an unlicensed 60 GHz mm-wave frequency band is designed on a 2-layer stack-up with a 36.4 mil (0.0364 inches) thick Megtron 6 substrate (high-performance and high-frequency PCB substrate material) with a lateral size of 1.5mm × 7 mm (≈ 0.3λ, × 1.4λ, at 60 GHz). To demonstrate the link performance enabled by the CFEA 140, a 5 mm face to face link was modeled in High-Frequency Structure Simulator (HFSS). The link supports two transmission bands with return losses higher than - 10 dB. One band is around 42 GHz while another is around 63 GHz.

Link level analysis results are summarized in Table 1.

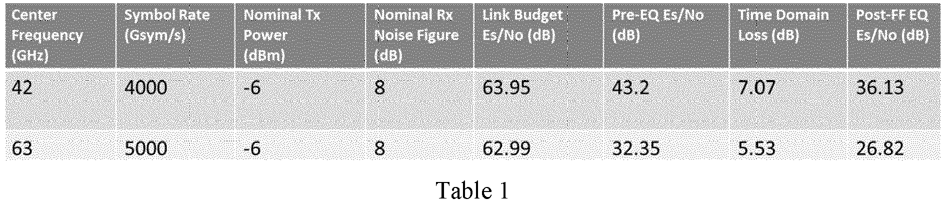

According to the Quadrature Amplitude Modulation (QAM) modulation depth vs its required Signal-to-Noise Ratio (SNR), this 5 mm face to face (F2F) link can support 4 GHz transmission bandwidth with at least 256-QAM, and hence it can support 32 Gbps when it operates at a center frequency of 42 GHz. Around 63 GHz, with a Post-FF EQ ES/No=26.82 dB, this link should be able to support 64-QAM with 5GHz transmission bandwidth, and consequentially support 30 Gbps data rate.

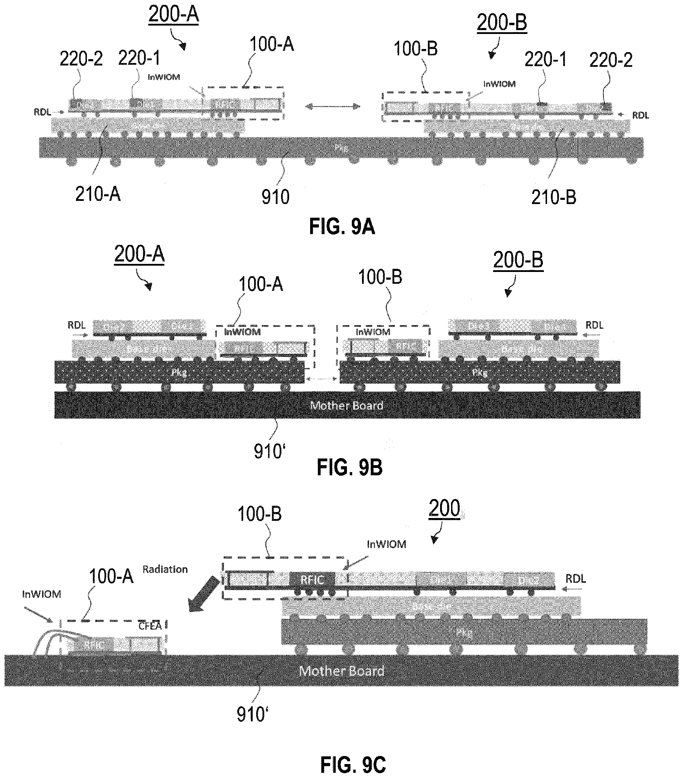

With example InWIOMs supporting 40 Gbps, a chip-to-chip wireless communication system is proposed as illustrated in **Fig. 9A****.** In this example wireless communication system, two separate chips 200-A, 200-B or even multiple separate chips can directly communicate with each other through respective InWIOM modules 100-A, 100-B co-packaged with them wirelessly either in the form of broadcasting or multi-drop. Chip 200-A comprises InWIOM module 100-A co-packaged and interfacing with a plurality of chiplets 220. Chip 200-B comprises InWIOM module 100-B co-packaged and interfacing with a plurality of chiplets 220. Chip 200-A and chip 200-B are mounted on respective base dies 210-A, 210-B. The base dies 210-A, 210-B are mounted on a common substrate 910, which may be a package substrate, for example. The separate chips 200-A, 200-B may be housed in a common package or in separate packages.

A package-to-package wireless communication network paradigm is proposed in **Fig. 9B** with respective InWIOM modules 100-A, 100-B being placed on separate packages 200-A, 200-B through die-to-package attachments. Package 200-A comprises InWIOM module 100-A co-packaged and interfacing with a chip comprising plurality of chiplets (die 1, die2). The chiplets (die 1, die2) are mounted on a base die. The base die and the InWIOM module 100-A are both mounted on a common package substrate. Package 200-B comprises InWIOM module 100-B co-packaged and interfacing with a chip comprising plurality of chiplets (die3, die4). The chiplets (die3, die4) are mounted on a common base die. The base die and the InWIOM module 100-B are both mounted on a common package substrate. The separate packages 200-A, 200-B may be mounted to a common motherboard 910'. Instead going through the package routing and mother board routing, the wireless link enabled by InWIOMs 100-A, 100-B consume less package areas simply because the link may only involve InWIOMs, a 100 µm die to package bump pitch, comparing to a 650 µm BAG pitch, if the signals must go through package BGA.

With InWIOMs, a wireless communication system for testing and debugging is also devised as presented in **Fig. 9C****.** In this system, two separate InWIOMs modules 100-A, 100-B are involved. InWIOM module 100-B is co-packaged with a plurality of chiplets (die1, die2), while InWIOM module 100-A is placed and wire-bonded to the motherboard 910'. In case, the signals are solely for debugging, the wireless link may exclude the sideband signals from imposing penalties on both the base die and package area. The reason is so obvious due to the reductions of the many sideband signals going through the base die and the package.

As can be seen in Figs 9A-C, the InWIOM modules 100A, 100-B are placed in close proximity to each other in order to provide a good communications link. In the illustrated example, the InWIOM modules 100A, 100-B face each other. More particularly, the antennas 140 of InWIOM modules 100A, 100-B may face each other.

Some examples of the present disclosure propose an integrated wireless io module 100 with a multiband compact folded edge antenna 140 for sideband signal and control signal segregation and transmission in a 3D heterogenous chiplet system. Some examples of the present disclosure propose an overhanging integrated wireless I/O module (InWIOM) which integrates a RFIC bare die with an mm-wave compact folded edge antenna on a simple 2-layer stack-up using Fan-Out Wafer Level Package (FOWPL). The InWIOM can be further co-packaged with heterogenous chiplets with FOWPL to provide the sideband/control signal segregation and wireless communication between chiplets, chip to mother board, and package to package. The overhanging InWIOM architecture may improve link performance by enabling clear line-of-sight wireless link, may reduce the pin counts reserved for sideband and some control signals, and hence less routing congesting between top and base dies, base die and package, as well as package and mother board. Further, more data throughput may be achieved through frequency multiplex/duplex and multiband transmission. Multidrop and broadcasting capability may be enabled. Examples of the present disclosure may slow down the die and package area growth, and hence reduce the die and package cost. The proposed 2-layer compact mm-wave folded edge antenna is cost effective solution. It also can be easily implemented in RDL and molding compound and easily integrated with RFIC bare die.

In the following, some examples of the proposed technique are presented:
An example (e.g., example 1) relates to a semiconductor package, comprising a substrate, a RFIC (die) attached to the substrate, optionally at least one semiconductor die attached to the substrate and coupled to the RFIC via one or more signal lines, a molding compound encapsulating the RFIC (die) and the optional semiconductor die, and an antenna formed on the molding compound and coupled to the RFIC (die).

Another example (e.g., example 2) relates to a previous example (e.g., example 1) or to any other example, wherein the optional at least one semiconductor die in the semiconductor package is configured to send and/or receive one or more baseband test and/or debug signals to/from the RFIC.

Another example (e.g., example 3) relates to a previous example (e.g., example 1 or 2) or to any other example, wherein the antenna is coupled to the RFIC via one or more redistribution layers of the semiconductor package.

Another example (e.g., example 4) relates to a previous example (e.g., examples 1 to 3) or to any other example, wherein the optional semiconductor die is coupled to the RFIC via one or more redistribution layers of the semiconductor package.

Another example (e.g., example 5) relates to a previous example (e.g., examples 1 to 4) or to any other example, wherein the molding compound laterally extends beyond the RFIC and the antenna is formed in or on the molding compound laterally adjacent to the RFIC.

Another example (e.g., example 6) relates to a previous example (e.g., examples 1 to 5) or to any other example, the antenna is formed on an edge of the molding compound.

Another example (e.g., example 7) relates to a previous example (e.g., examples 1 to 6) or to any other example, wherein the semiconductor package further comprises a ground plane formed in the molding compound as a counterpoise to the antenna.

Another example (e.g., example 8) relates to a previous example (e.g., examples 7) or to any other example, wherein the ground plane is formed in at least a first metal layer in the molding compound and the antenna is formed in at least a second metal layer above or below the first metal layer.

Another example (e.g., example 9) relates to a previous example (e.g., examples 7 or 8) or to any other example, wherein the antenna is coupled to the ground plane by means of at least one shorting via.

Another example (e.g., example 10) relates to a previous example (e.g., examples 7 to 9) or to any other example, wherein the antenna is coupled to the RFIC by means of a feeding via extending from or through the ground plane.

Another example (e.g., example 11) relates to a previous example (e.g., examples 7 to 10) or to any other example, wherein the antenna comprises a floating via extending from the antenna or second metal layer towards the ground plane or the first metal layer.

Another example (e.g., example 12) relates to a previous example (e.g., examples 1 to 11) or to any other example, wherein the antenna comprises a first radiating element for a first frequency band and at least a second radiating element for a second frequency band, wherein the antenna is coupled to the RFIC and a ground plane via the first radiating element and the second radiating element is coupled to the first radiating element.

Another example (e.g., example 13) relates to a previous example (e.g., example 12) or to any other example, wherein the first radiating element comprises an inverted-F antenna (IFA) structure and the second radiating element comprises an L-shape structure.

Another example (e.g., example 14) relates to a previous example (e.g., examples 12 to 13) or to any other example, wherein the first radiating element linearly extends in a first direction and the second radiating element linearly extends in parallel to the first radiating element.

Another example (e.g., example 15) relates to a previous example (e.g., examples 12 to 14) or to any other example, wherein the second radiating element is attached to the first radiating element at a first end of the first radiating element and linearly extends beyond an opposing second end of the first radiating element.

Another example (e.g., example 16) relates to a previous example (e.g., examples 14 or 15) or to any other example, wherein the second radiating element comprises a first portion extending in the first direction and a second portion extending towards the first radiating element in a second direction perpendicular to the first direction.

Another example (e.g., example 17) relates to a previous example (e.g., example 16) or to any other example, wherein a gap extends between the second end of the first radiating element and the second portion of the second radiating element.

Another example (e.g., example 18) relates to a previous example (e.g., examples 7 to 17) or to any other example, wherein the ground plane comprises a cutout portion underneath the antenna.

Another example (e.g., example 19) relates to a previous example (e.g., examples 1 to 18) or to any other example, wherein the RFIC is configured to send and/or receive test and/or debug signals for the semiconductor package via the antenna.

Another example (e.g., example 20) relates to a previous example (e.g., examples 1 to 19) or to any other example, wherein the RFIC comprises a baseband interface configured to receive one or more baseband test and/or debug signals via one or more signal lines, a modulator configured to modulate an RF carrier signal based on the one or more baseband test and/or debug signals to obtain a modulated RF signal, and a transmit interface configured to feed the modulated RF signal to the antenna.

Another example (e.g., example 21) relates to a previous example (e.g., examples 1 to 20) or to any other example, wherein the RFIC comprises a receive interface configured to receive a modulated RF signal from the antenna, a demodulator configured to demodulate the RF carrier signal to obtain one or more baseband test and/or debug signals, and a baseband interface configured to transmit the one or more baseband test and/or debug signals via one or more signal lines.

Another example (e.g., example 22) relates to a previous example (e.g., examples 1 to 21) or to any other example, wherein the antenna is configured as a mm-wave antenna.

An example (e.g., example 23) relates to wireless communication system comprising a substrate, a first semiconductor package mounted on the substrate, wherein the first semiconductor package comprises a first RFIC, a first molding compound encapsulating the first RFIC, and a first antenna formed on a surface of the first molding compound and coupled to the first RFIC. The wireless communication system also comprises a second semiconductor package mounted on the substrate, wherein the second semiconductor package comprises a second RFIC, a second molding compound encapsulating the second RFIC, and a second antenna formed on a surface of the second molding compound and coupled to the second RFIC. The first and the second semiconductor packages are configured to wirelessly communicate with each other using the first RFIC with the first antenna and the second RFIC with the second antenna.

Another example (e.g., example 24) relates to a previous example (e.g., example 23) or to any other example, wherein the first and the second semiconductor packages are configured to wirelessly exchange test and/or debug signals using the first RFIC with the first antenna and the second RFIC with the second antenna.

Another example (e.g., example 25) relates to a previous example (e.g., example 23 or 24) or to any other example, wherein the first and the second semiconductor packages are arranged on the substrate such that the first and the second antennas face each other.

An example (e.g., example 26) relates to wireless communication method. The wireless communication method includes providing an RFIC die on a package substrate, optionally providing at least one further semiconductor die on the package substrate, coupling the optional at least one further semiconductor die to the RFIC die via one or more signal lines in the package, encapsulating the RFIC die and the optional least one further semiconductor die using a molding compound, forming an antenna in or on the molding compound, and coupling the antenna to the RFIC die.

Another example (e.g., example 27) relates to a previous example (e.g., example 26) or to any other example, further comprising sending and/or receiving test and/or debug signals for the semiconductor package or the at least one further semiconductor die via the RFIC die and the antenna.

The aspects and features described in relation to a particular one of the previous examples may also be combined with one or more of the further examples to replace an identical or similar feature of that further example or to additionally introduce the features into the further example.

It is further understood that the disclosure of several steps, processes, operations or functions disclosed in the description or claims shall not be construed to imply that these operations are necessarily dependent on the order described, unless explicitly stated in the individual case or necessary for technical reasons. Therefore, the previous description does not limit the execution of several steps or functions to a certain order. Furthermore, in further examples, a single step, function, process or operation may include and/or be broken up into several sub-steps, - functions, -processes or -operations.

If some aspects have been described in relation to a device or system, these aspects should also be understood as a description of the corresponding method. For example, a block, device or functional aspect of the device or system may correspond to a feature, such as a method step, of the corresponding method. Accordingly, aspects described in relation to a method shall also be understood as a description of a corresponding block, a corresponding element, a property or a functional feature of a corresponding device or a corresponding system.

The following claims are hereby incorporated in the detailed description, wherein each claim may stand on its own as a separate example. It should also be noted that although in the claims a dependent claim refers to a particular combination with one or more other claims, other examples may also include a combination of the dependent claim with the subject matter of any other dependent or independent claim. Such combinations are hereby explicitly proposed, unless it is stated in the individual case that a particular combination is not intended. Furthermore, features of a claim should also be included for any other independent claim, even if that claim is not directly defined as dependent on that other independent claim.

## Claims

1. A semiconductor package (100; 200), comprising
a substrate (110);
a radio frequency integrated circuit, RFIC (120), attached to the substrate (110);
at least one semiconductor die (220) attached to the substrate (110) and coupled to the RFIC (120) via one or more signal lines (150);
a molding compound (130) encapsulating the RFIC (120) and the semiconductor die (220); and
an antenna (140) formed on the molding compound (130) and coupled to the RFIC (140).

2. The semiconductor package (100; 200) of claim 1, wherein the at least one semiconductor die is configured to send and/or receive one or more baseband test and/or debug signals to/from the RFIC.

3. The semiconductor package (100; 200) of any one of the previous claims, wherein the antenna and/or the semiconductor die is coupled to the RFIC via one or more redistribution layers of the semiconductor package.

4. The semiconductor package (100; 200) of any one of the previous claims, wherein the molding compound laterally extends beyond the RFIC and the antenna is formed on the molding compound laterally adjacent to the RFIC.

5. The semiconductor package (100; 200) of any one of the previous claims, further comprising
a ground plane (510) formed in the molding compound (130) as a counterpoise to the antenna (140).

6. The semiconductor package (100; 200) of claim 5, wherein the antenna (140) is coupled to the ground plane (510) by means of at least one shorting via and/or the antenna (140) is coupled to the RFIC (140) by means of a feeding via (160) extending from or through the ground plane (510)

7. The semiconductor package (100; 200) of any one of claims 5 or 6, wherein the antenna (140) comprises a floating via (170) extending from the antenna (140) towards the ground plane (510).

8. The semiconductor package (100; 200) of any one of the previous claims, wherein the antenna (140) comprises a first radiating element (140-B) for a first frequency band and at least a second radiating element (140-A) for a second frequency band, wherein the antenna (140) is coupled to the RFIC and a ground plane via the first radiating element (140-B) and the second radiating element (140-A) is coupled to the first radiating element.

9. The semiconductor package (100; 200) of claim 10, wherein the first radiating element (140-B) comprises an inverted-F antenna, IFA, structure and the second radiating element (140-A) comprises an L-shape structure.

10. The semiconductor package (100; 200) of claim 8 or 9, wherein the first radiating element (140-B) linearly extends in a first direction and the second radiating element (140-A) linearly extends in parallel to the first radiating element.

11. The semiconductor package (100; 200) of any one of claims 8 to 10, wherein the second radiating element (140-A) is attached to the first radiating element (140-B) at a first end of the first radiating element (140-B) and linearly extends beyond an opposing second end of the first radiating element (140-B).

12. The semiconductor package (100; 200) of any one of claims 10 or 11, wherein the second radiating element (140-A) comprises a first portion extending in the first direction and a second portion extending towards the first radiating element (140-B) in a second direction perpendicular to the first direction.

13. The semiconductor package (100; 200) of claim 12, wherein a gap (41) extends between the second end of the first radiating element (140-B) and the second portion of the second radiating element (140-A).

14. The semiconductor package (100; 200) of any one of claims 5 to 13, wherein the ground plane (510) comprises a cutout portion (514) underneath the antenna (140).

15. The semiconductor package (100; 200) of any one of the previous claims, wherein the RFIC (120) comprises
a baseband interface (310) configured to receive one or more baseband test and/or debug signals via one or more signal lines;
a modulator (320) configured to modulate an RF carrier signal based on the one or more baseband test and/or debug signals to obtain a modulated RF signal; and
a transmit interface (330) configured to feed the modulated RF signal to the antenna;
a receive interface (330) configured to receive a modulated RF signal from the antenna;
a demodulator (340) configured to demodulate the RF carrier signal to obtain one or more baseband test and/or debug signals; and
a baseband interface (350) configured to transmit the one or more baseband test and/or debug signals via one or more signal lines.
